# EUROPEAN PATENT SPECIFICATION

(11) **EP 2 854 191 B1**
(45) Date of publication and mention of the grant of the patent: **25.05.2016**
(21) Application number: 13186633.7
(22) Date of filing: 30.09.2013
(51) Int. Cl.: H01L 35/30

(54) **Thermoelectric Generator with Expandable Container**
Thermoelektrischer Generator mit erweiterbarem Behälter
Générateur thermoélectrique avec récipient expansible

(43) Date of publication of application: 01.04.2015
(73) Proprietor: Airbus Defence and Space GmbH, 85521 Ottobrunn (DE)
(72) Inventor: Elefsiniotis, Alexandros, 81375 München (DE); Kokorakis, Nikolaos, 81375 München (DE); Becker, Thomas, 27711 Osterholz-Scharmbeck (DE); Schmid, Ulrich, 1140 Wien (AT)
(74) Representative: Rasch, Michael

(56) References cited:
- EP-A2- 2 475 019
- EP-A2- 2 482 352
- WO-A1-2007/133069
- WO-A1-2011/125231
- DE-A1-102009 038 925
- JP-A- 2007 116 086
- US-A- 3 607 444
- US-A1- 2012 073 276
- D. SAMSON ET AL: "Wireless sensor node powered by aircraft specific thermoelectric energy harvesting", SENSORS AND ACTUATORS A: PHYSICAL, vol. 172, no. 1, 1 December 2011 (2011-12-01), pages 240-244, XP055071278, ISSN: 0924-4247, DOI: 10.1016/j.sna.2010.12.020

## Description

The invention relates to a device for generating electrical energy comprising at least a thermoelectric generator arranged between a surface subjected to thermal exposure and a container containing a phase change material according to the preamble of claim 1.

Such a device is known from DE 10 2009 038925 A1.

It is known to generate energy using thermoelectric generators which are devices that convert a temperature gradient between two surfaces directly into electrical energy, using the so-called "Seebeck effect". One of these surfaces is subjected to thermal exposure such as high or low temperature. For example, it is possible to attach one side of a thermoelectric generator to an aircraft fuselage which is exposed to the ambient temperature of the aircraft. On the ground, this temperature is more or less the air temperature on the ground. During flight, the ambient temperature may be between -20°C and -50°C depending on the flight conditions. If the other surface of the thermoelectric generator is thermoconductively connected to a container containing a phase change material such as water, the temperature gradient between the outside and the phase change material can be converted into electric energy. For example, if the outside temperature is -20°C and the temperature of the phase change material is +20°C, the phase change material will cool to the phase change point (freezing point) of the phase change material, namely 0°C in the case of water and remain at this temperature until all of the phase change material is solidified or frozen. During this time a constant electrical energy flow can be achieved. After all of the phase change material is frozen, its temperature will approach the outside temperature while at the same time due to the decreasing temperature gradient between the two sides of the thermoelectric generator the electrical current will decrease and will reach a value close to 0. Afterwards, if the outside temperature rises again, the same effect can be achieved, only in that the temperature difference is opposite and thus the current flows in opposite direction.

Water used as phase change material has a density change of about 10% when passing the phase change point. As a consequence, the container holding the water has to be able to withstand the high forces associated with this density change. In the state of the art, an expansion gap filled with air is used to absorb these forces so that the container is not destroyed during operation. In case the orientation of the device may change during operation, the air in the expansion gap may leak into the container itself and deteriorate the performance as air is a very good insulator and if an air bubble gets near the surface, which thermally interacts with the thermoelectric generator, the heat flow may be severely reduced leading to a significant reduction in generated electrical energy and, thus, to a significant reduction of the overall efficiency.

Additional devices for generating electrical energy are known from US 2012/073276 A1, WO 2011/125231 A1 and JP 2007/116086.

It is object of the present invention to provide a device for generating electrical energy comprising at least a first thermoelectric generator arranged between a surface subjected to thermal exposure and a container containing a phase change material with improved overall efficiency irrespective of the installation orientation of the energy harvesting device or the motion of the technical system the energy harvesting device is attached to.

This object is solved by the invention as set out in claim 1. Advantageous embodiments are set out in the dependent claims.

As the container thus has a variable volume the density change of the phase change material during solidification or melting does not lead to any increased stress of the container material and it is also not necessary to include any gas within the container to compensate for the density change. It is possible to have a container made of a part which is not expandable and another part which is expandable. The non-expandable part may be shaped to adapt to the shape of the thermoelectric generator, especially to be flat. The novel embodiment has an improved overall efficiency and is not dependent on the installation orientation or the motion of the technical system the energy harvesting device is attached to. The device includes force generating means which biases the container against said thermoelectric generator. According to the invention the biasing means comprise at least one resilient element which is arranged between said container and a device housing. This embodiment is easy to manufacture.

More preferably, the device includes a housing surrounding said container including a top structure, wherein at least one spring member extending between said top structure and said elastically expandable container wall effecting a force against said wall. This embodiment is a simple but efficient structure to produce a pressure which acts on the container.

According to a preferred embodiment of the invention, the container is completely filled with the phase change material. By this measure, any negative effects of a gas inside the container can be avoided.

According to another preferred embodiment of the invention, the complete container is elastically expandable. This eases production and avoids any problems with leakage which would be associated with a container having two different materials.

According to another preferred embodiment of the invention, the container is made of a synthetic rubber, such asbutyl rubber, nitrile rubber.

According to another preferred embodiment of the invention, the container is a balloon. Such a balloon is easy to produce and to fill. Also can it be easily deformed and, thus, shaped to adapt to any surfaces. Preferentially, the springe force balances the internal pressure level of the balloon in such a way that the internal pressure does not exceed the mechanical fracture limit of the specific balloon material when undergoing volume related changes based on e.g. phase changes or temperature effects. Even most preferentially, the internal balloon pressure is kept constant independent of the flight profile by a tailored spring constant.

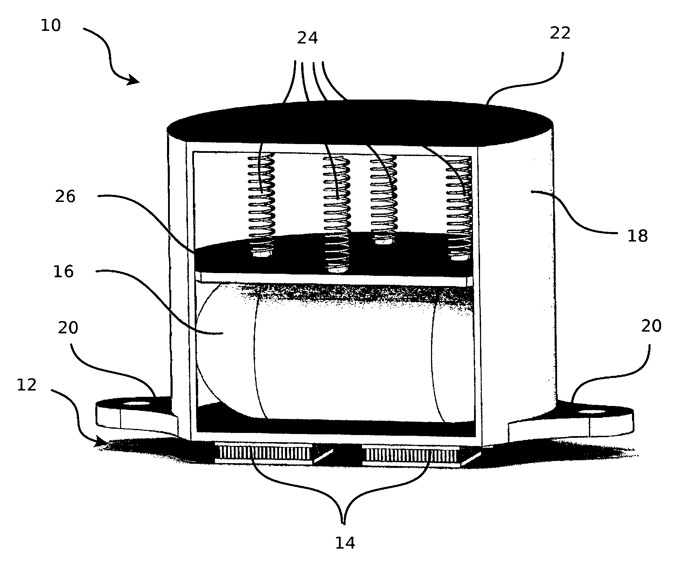

An embodiment of the invention will hereinafter be described with reference to the accompanying drawing, which is a schematic perspective view of a generator device 10 according to an embodiment of the invention which can be attached to a surface 12 subjected to thermal exposure. In this respect, thermal exposure should be understood as being a temperature which changes in respect of the freezing temperature of a phase change material which is held in a container 16. The surface 12 will be subjected to a temperature higher or lower than the freezing temperature of the phase change material for a considerable time. More specifically, the temperature will remain lower than the freezing temperature for a certain time span and then rise above the freezing temperature for another time span.

Attached to the surface 12 are two thermoelectric generators 14 which convert heat (i.e. a temperature differences) of two opposing sides directly into electrical energy, using a phenomenon called the thermoelectric effect. The thermoelectric generators 14 are electrically coupled to appropriate devices for converting the electrical energy to the specific needs. These can be sensors and/or transmitters with low energy consumption or energy storing devices such as rechargeable batteries or supercapacitors or a combination of both.

The respective upper sides of the thermoelectric generators 14 are thermoconductively coupled to the container 16 holding the phase change material. In a preferred embodiment, the phase change material is water but it can also be a mixture of water with other substances or another material which has a density change when passing the phase change point.

The generator device 10 includes a housing 18 which surrounds the container 16 and which includes mounting flanges 20 for fixing the generator device 10, especially to the surface 12. The housing 18 includes a cover portion 22. Attached to the inner part of the cover portion 22 are a number of spring elements 24 which act upon a pressure plate 26. The pressure plate 26 presses against the balloon shaped container 16 which has elastically expandable walls. The container 16 is flattened to some extent and thoroughly pressed against the thermoelectric generators 14. In case the shown embodiment has the phase change material inside the container 16 in a fluid state then in case of solidification the volume of the container 16 increases to some extent (in case of water by about 10%) which moves the pressure plate 26 against the force of the spring elements 24 some distance towards the cover portion 22. In case of a subsequent liquefaction (melting) due to the reduced volume of the liquid phase change material, the pressure plate 26 is again moved back to the present position due to the force of the spring elements 24.
- 10: generator device
- 12: surface
- 14: thermoelectric generators
- 16: container
- 18: housing
- 20: mounting flanges
- 22: cover portion
- 24: spring elements
- 26: pressure plate

## Claims

1. A device (10) for generating electrical energy comprising at least a thermoelectric generator (14) arranged between a surface (12) subjected to thermal exposure and a container (16) containing a phase change material, wherein at least a part of a wall of the container (16) is elastically expandable, further including force generating means (24) which bias the container (16) against said thermoelectric generator (14), **characterized in that** said force generating means comprise at least one resilient element (24) which is arranged between said container (16) and a device housing (18).

2. The device of claim 1, **characterized in that** said container (16) is completely filled with the phase change material.

3. The device of claim 1 or 2, **characterized in that** the complete container (16) is elastically expandable.

4. The device of claim 1, **characterized in that** said housing (18) surrounds said container (16) and includes a cover portion (22), wherein at least one spring element (24) extending between said cover portion (22) and said elastically expandable container wall (16) effecting a force against said wall.

5. The device of any of the preceding claims, **characterized in that** said container (16) is made of a synthetic rubber.

6. The device of any of the preceding claims, **characterized in that** said container (16) is a balloon.

7. The device of claim 6, **characterized in that** said balloon-shaped container (16) has a constant internal pressure.

## Patentansprüche

1. Vorrichtung (10) zur Erzeugung elektrischer Energie, welche wenigstens einen thermoelektrischen Generator (14) umfasst, der zwischen einer Fläche (12), die Gegenstand thermischer Exposition ist, und einem Behälter (16), der ein Phasenwechselmaterial enthält, angeordnet ist, wobei wenigstens ein Teil einer Wand des Behälters (16) elastisch dehnbar ist, ferner Krafterzeugungsmittel (24) aufweisend, welche den Behälter (16) gegen den thermoelektrischen Generator (14) vorbelasten, **dadurch gekennzeichnet, dass** die Krafterzeugungsmittel wenigstens ein elastisches Element (24) umfassen, welches zwischen dem Behälter (16) und einem Vorrichtungsgehäuse (18) angeordnet ist.

2. Vorrichtung nach Anspruch 1, **dadurch gekennzeichnet, dass** der Behälter (16) vollständig mit dem Phasenwechselmaterial gefüllt ist.

3. Vorrichtung nach Anspruch 1 oder 2, **dadurch gekennzeichnet, dass** der vollständige Behälter (16) elastisch dehnbar ist.

4. Vorrichtung nach Anspruch 1, **dadurch gekennzeichnet, dass** das Gehäuse (18) den Behälter (16) umgibt und einen Abdeckungsabschnitt (22) aufweist, wobei wenigstens ein Federelement (24), das sich zwischen dem Abdeckungsabschnitt (22) und der elastisch dehnbaren Behälterwand (16) erstreckt, eine Kraft auf die Wand ausübt.

5. Vorrichtung nach einem der vorhergehenden Ansprüche, **dadurch gekennzeichnet, dass** der Behälter (16) aus einem Synthesekautschuk hergestellt ist.

6. Vorrichtung nach einem der vorhergehenden Ansprüche, **dadurch gekennzeichnet, dass** der Behälter (16) ein Ballon ist.

7. Vorrichtung nach Anspruch 6, **dadurch gekennzeichnet, dass** der ballonförmige Behälter (16) einen konstanten Innendruck aufweist.

## Revendications

1. Dispositif (10) de génération d'énergie électrique comprenant au moins un générateur thermoélectrique (14) disposé entre une surface (12) soumise à une exposition thermique et un récipient (16) contenant un matériau de variation de phase, dans lequel au moins une partie d'une paroi du récipient (16) est expansible élastiquement, incluant en outre un moyen de génération de force (24) qui polarise le récipient (16) à l'opposé dudit générateur thermoélectrique (14), **caractérisé en ce que** ledit moyen de génération de force comprend au moins un élément résilient (24) qui est agencé entre ledit récipient (16) et un logement du dispositif (18).

2. Dispositif selon la revendication 1, **caractérisé en ce que** ledit récipient (16) est complètement rempli avec le matériau de variation de phase.

3. Dispositif selon la revendication 1 ou 2, **caractérisé en ce que** le récipient complet (16) est expansible élastiquement.

4. Dispositif selon la revendication 1, **caractérisé en ce que** ledit logement (18) entoure ledit récipient (16) et inclut une portion de couvercle (22), dans lequel au moins un élément de ressort (24) s'étendant entre ladite portion de couvercle (22) et ladite paroi de récipient expansible élastiquement (16) exerce une force contre ladite paroi.

5. Dispositif selon une quelconque des revendications précédentes, **caractérisé en ce que** ledit récipient (16) est fabriqué en caoutchouc synthétique.

6. Dispositif selon une quelconque des revendications précédentes, **caractérisé en ce que** ledit récipient (16) est un ballon.

7. Dispositif selon la revendication 6, **caractérisé en ce que** ledit récipient en forme de ballon (16) a une pression interne constante.
